# EUROPEAN PATENT APPLICATION

(11) **EP 2 544 229 A1**
(43) Date of publication of application: **09.01.2013**
(21) Application number: 11172958.8
(22) Date of filing: 07.07.2011
(51) Int. Cl.: H01L 23/62, H01L 25/07

(54) **Power semiconductor arrangement**

(71) Applicant: ABB Research Ltd., 8050 Zürich (CH)
(72) Inventor: Schulz, Nicola, 5300 Turgi (CH); Schuderer, Juergen, 8047 Zürich (CH); Behzadi, Bahar, 8713 Uerikon (CH); Brem, Franziska, 8700 Küsnacht (CH)
(74) Representative: ABB Patent Attorneys

(57) **Abstract**

The present invention relates to a power semiconductor arrangement (10) comprising a power semiconductor device (12), having an emitter electrode and a collector electrode, wherein the collector electrode is electrically connected to a lower electrode (14) and wherein the emitter electrode is electrically connected to an upper electrode (16), wherein the arrangement (10) further comprises a failure mode contact element (30) and a low temperature melting material (28), the low temperature melting material (28) being arranged between the failure mode contact element (30) and the semiconductor device (12), wherein the failure mode contact element (30) is spring loaded towards the low temperature melting material (28) and comprises at least one contact portion (32) being spaced apart from the lower electrode (14) in a distance being smaller or equal than the thickness of the low temperature melting material (28) in a regular working mode of the power semiconductor arrangement (10). A power semiconductor arrangement (10) according to the invention provides an improved failure mode.

## Description

### Technical Field

The Invention relates to a power semiconductor arrangement. In particular, the invention relates to a power semiconductor arrangement with the capability to form an electrical short circuit after a failure event. The invention further relates to a power semiconductor module comprising a power semiconductor arrangement.

### Background Art

In the case of high power semiconductor arrangements, or modules, respectively, it has been found that a defect leads to the formation of an electrical short circuit. With large chip areas, this short circuit remains stable over a long time. If, for example, redundant thyristors are provided in a stack of thyristors connected in series, the remaining, intact thyristors withstand the voltage during the switched-off phase, and the stack remains operative. Defective thyristors can be replaced subsequently in the course of planned servicing work.

In a thyristor module, for example, the semiconductor, that is to say the silicon (Si), is in mechanical and electrical contact with and arranged between two molybdenum wafers. Silicon has a melting point of 1420°C, wherein that of molybdenum is higher, and the intermetallic compounds of silicon and molybdenum have a still higher melting point. Thus, in the event of a defect, the silicon melts locally first of all and, as current flows, it forms a conductive channel composed of molten silicon over the entire thickness of the semiconductor. This defect zone can propagate and/or move, but will only affect a small part of the chip area. In hermetically sealed housings, the molten silicon does not oxidize but reacts with molybdenum to form a type of powder. This process continues until all the silicon has been consumed, and may possibly extend over years.

In contrast to thyristor semiconductor components, insulated gate bipolar transistor (IGBT) chips, for example, are not produced as large-area units and, normally, a plurality of small-area individual chips are arranged isolated and alongside one another in the insulated gate bipolar transistor modules.

It has been found that no stable short circuits of the type described above can be expected with insulated gate bipolar transistor modules, for example. This is primarily due to the reduced area of the individual chips, and the small silicon volume. The pseudo-stable phase of a short circuit lasts only for a limited time . Furthermore, the housings are often deliberately not hermetically sealed, so that the molten silicon can react with oxygen and form insulating silica (SiO₂). Without any stable short-circuit path in the defective chip, the worst-case situation which can arise is as follows. If the remaining chips in a module, including the actuation, are still intact, they can withstand voltage during the switched-off phase. The current is then forced through the defective chip and, at voltages up to the break down voltage of the intact chips, the current may lead to a plasma being formed, with a very high power density. This results in a possible severe damage of the module..

To avoid this problem, known from EP 0 989 611 B1 is a power semiconductor module which is formed from small-area individual chips and in which a short circuit of an individual chip does not lead to total failure of the module. According to this prior art, a layer composed of a suitable material, for example, silver or aluminium, is brought into direct contact with one or both of the main electrodes of the silicon semiconductor. The material of this layer must form a eutectic alloy with silicon. In the event of a short circuit, the entire sandwich structure is heated and, once the melting point of the eutectic mixture is reached, a conductive melt starts to form on the contact surface between the said layer and the silicon. This zone can then expand over the entire thickness of the semiconductor, and thus forms a metallically conductive channel. A sufficient electric contact is thereby provided by means of an electric contact piston.

However, such a technology may suffer from a reduced lifetime of the short circuit failure mode capability, since the conductive eutectic alloy ages with time, in particular at elevated currents. It is reported in literature that the mechanisms responsible for this aging are the formation of brittle intermetallics (Al, Si, Mo) and the presence of intermetallic corrosion leading to loss of chip adhesion.

### Summary of invention

It is therefore an object of the present invention to provide an improved power semiconductor arrangement and an improved power semiconductor module which shall obviate at least one of the disadvantages known in the art.

In particular, it is an object of the present invention to provide a power semiconductor arrangement and a power semiconductor module which provides the capability to fall into a stable short circuit after a failure event with an improved reliability as well as durability and current carrying capability.

These objects are achieved by a power semiconductor arrangement according to claim 1. These objects are furthermore achieved by a power semiconductor module according to claim 15. Preferred embodiments of the present invention are defined in the dependent claims.

The invention relates to a power semiconductor arrangement comprising a power semiconductor device, having a first main electrode and a second main electrode, wherein the second main electrode is electrically connected to a lower electrode and wherein the first electrode is electrically connected to an upper electrode, wherein the arrangement further comprises a failure mode contact element and a low temperature melting material, the low temperature melting material being arranged between the failure mode contact element and the semiconductor device, wherein the failure mode contact element is spring loaded towards the low temperature melting material and comprises at least one contact portion being spaced apart from the lower electrode in a distance being smaller or equal than the thickness of the low temperature melting material in a regular working mode of the power semiconductor arrangement.

According to the invention, a low temperature melting material shall particularly mean a material having a melting point being in a range sufficiently low, so that a temperature appearing at a chip failure leads to the low temperature melting material to melt. The low temperature melting material may thereby be partly or solely formed of the above identified material. The low melting material may also comprise a compound structure of several materials such as small particles being embedded into a matrix material in which case the low melting material is reinforced.

Additionally, a failure mode contact element according to the present invention shall particularly mean a contact element which only provides its function as a contact element in case of a failure, such as particularly a failure of the semiconductor device. A contact portion shall thereby particularly mean a defined portion which is designed for coming in contact with the lower electrode in case of a failure of the semiconductor device.

A lower electrode may furthermore be any electrode the second main electrode of the semiconductor device is preferably electrically connected to. For example, the lower electrode may be formed by a conventional base plate. Accordingly, an upper electrode may be any electrode the first main electrode of the semiconductor device is preferably electrically connected to. For example, the upper electrode may be formed by a conventional lid. The first main electrode of the semiconductor device may be formed by the emitter electrode and the second main electrode may be formed by the collector electrode. It may also be the other way around.

Referring to this, a collector electrode or a emitter electrode being electrically connected to a lower electrode or an upper electrode, respectively, shall particularly mean, that the emitter electrode and the collector electrode is directly connected to the respective further electrode, or that one or a plurality of electrically conductive parts, or layers, respectively, are arranged there between.

A regular working mode of the power semiconductor device according to the invention shall further mean a working mode of the power semiconductor arrangement in which no failure appears, i.e. a normal and desired working mode.

The power semiconductor arrangement according to the invention addresses the above identified objects and provides a reliable and permanent electrical short-circuit capability being formed if a semiconductor chip fails.

In detail, in case a power semiconductor device fails, heat is generated through a formed short circuit. The generated heat leads to the low temperature melting material to melt. Due to the fact that the failure mode contact element is spring loaded e.g. by a spring, the spring pressure, which might be between 0.1 MPa to 100 MPa, of the spring forces the liquid, i.e. the molten material to flow away. Consequently, the failure mode contact element may move in the direction of the lower electrode, or the semiconductor device, respectively. Due to the fact that the distance of the contact portion of the failure mode contact element to the lower electrode is smaller or equal than the thickness of the unmolten low temperature melting material, the contact portion of the failure mode contact element comes in contact with the lower electrode particularly by being pressed against the lower electrode.

Especially in case the lower electrode is formed by or is part of a base plate, the latter is cooled in order to transport heat from the semiconductor device. Consequently, the formed electrical contact is cooled as well resulting in an especially stable and durable contact being able to carry high currents even over a long period of time. This allows the short-circuit capability being formed in case of a semiconductor chip failure having an especially high durability.

Additionally, due to the fact that the contact between the failure mode contact element and the lower electrode is formed solely by the influence of the generated heat and thus exclusively by the physical effects occurring during and after the chip failure, an autonomous formation of an electrical bypass is provided. Consequently, no further external means for triggering the bypass are required leading to an improved reliability of the bypass of the semiconductor device according to the invention.

Apart from that, the arrangement according to the invention is compatible to the general layout being provided for power semiconductor arrangements, or power semiconductor modules, respectively. Consequently, the implementation of the power semiconductor arrangement into a variety of applications is not problematic leading to a broad application range of the power semiconductor arrangement according to the invention.

In a preferred embodiment of the present invention, the failure mode contact element may be spring loaded towards the low temperature melting material by a contact piston. In detail, the failure mode contact element may be spring loaded by a contact piston being provided for contacting the semiconductor device, or its first main electrode, respectively. According to this embodiment, the present invention may easily be implemented into a general layout of power semiconductor arrangements using contact pistons. According to this, no additional elements have to be provided for spring loading the failure mode contact element. Consequently, the arrangement according to this embodiment is especially cost saving to form. Apart from that, by using a contact piston for spring loading the failure mode contact element, appropriate spring forces may be generated ensuring a reliable functionality of the arrangement according to the invention.

In a further preferred embodiment of the present invention, the failure mode contact element may comprise a layer proceeding in a plane between the power semiconductor device and the upper electrode, and the at least one contact portion may proceed at least partly in a direction being directed towards the lower electrode. This is a very stable arrangement which is easy to form and which may be implemented in most known power semiconductor arrangements.

The failure mode contact element may simply be added as a further layer or element into a structure comprising the power semiconductor device. It does not inhibit the functionality of the arrangement and of the spring loaded contact piston. Additionally, it may be formed very flat so that the dimensions of the power semiconductor arrangement may be kept within a required range. Additionally, the at least one contact portion proceeding at least partly in a direction being directed towards the lower electrode may form an electrically conducting path in a simple manner. It is thereby possible, for example, by varying the shape, dimension and number of contact portions, to adapt the failure mode contact element to the desired application.

It may furthermore be preferred that the failure mode contact element is at least partly formed from molybdenum, aluminium or copper or an alloy containing molybdenum, aluminium or copper. These materials provide advantageous properties with respect to the desired formation of a current path. In detail, such materials provide good electrical conductivity and a low contact resistance especially with respect to copper, good mechanical strength especially with respect to molybdenum, or are easy to manufacture especially with respect to aluminium. However, the material may be chosen in dependence of the used compound of the low melting material. In detail, due to the fact that in case the low melting material melts, further conductive paths are generated, the temperature is kept low from this point of time. Consequently, by using a low melting material having an especially low melting point, the melting point of the failure mode contact element may be low as well thereby anyhow decreasing the danger of the failure mode contact element to be damaged in case of a failure.

It may furthermore be preferred that the failure mode contact element is at least partly coated with a precious metal, such as silver or gold. It is especially preferred that the at least one contact portion is coated with the aforementioned materials at its side facing towards the lower electrode, i.e. at the region, the contact portion is designed to come in contact with the lower electrode in case of a failure. This allows to further reduce the contact resistance and thus to improve the current carrying capability. Furthermore, the heat generated in case of a failure may be further reduced and the durability of the short circuit failure mode may be improved.

In a further embodiment of the present invention, one contact portion may be provided being formed ring-shaped. This allows having a large-dimensioned contact area which enables high currents flowing through the failure mode contact element. Additionally, the heat generated may be reduced which further improves the durability of a short-circuit failure mode and furthermore of the power semiconductor arrangement as such.

Alternatively, a plurality of contact portions may be provided being designed as contact pins. According to this embodiment, the movement of the failure mode contact element towards the lower electrode may be improved due to the fact that contact pins do not exercise a great resistance on a silicone gel mostly being present on the lower electrode. In contrast thereto, the failure mode contact element may slide through the gel smoothly. Consequently, a well-defined and reliable movement behaviour of the failure mode contact element may be provided in case of a failure.

It may furthermore be preferred that at least one passage is provided in the failure mode contact element, in particular in the at least one contact portion. This allows the silicone gel mostly being arranged on top of the lower electrode to pass through the failure mode contact element, or through the passage respectively. One or several passages in the failure mode contact element could also serve to allow the molten low-melting material to pass through the passage(s). This leads to an improved displacement of the low-melting material and thus to a more reliable movement of the failure mode contact element in order to close the electrical bypass. Consequently, the movement of the failure mode contact element down to the lower electrode is improved by the fact that no overpressure may be generated between the failure mode contact element, or especially the contact portion thereof, and the power electronic device. As a result, the reliability of the failure mode capability according to the invention may be improved. From the above it may be seen that this embodiment is especially useful in case the contact portion is formed ring-shaped, in which case the at least one passage is provided in the contact portion, or in case the at least one passage is provided in the layer of the failure mode contact element lying next to the layer structure formed by e.g. the power semiconductor device.

In a further preferred embodiment of the present invention a solder material is provided arranged at the bottom side of the at least one contact portion. A solder material in the sense of the present invention shall particularly mean a material being capable of forming a brazed or soldered connection. This embodiment allows a stable contact between the failure mode contact element and the lower electrode being established. In detail, the solder material forms a soldered or brazed connection between the failure mode contact element and the lower electrode under the current flowing conditions due to the generated heat. Apart from the improved stability of the formed connection between the failure mode contact element and the lower electrode, an enlarged contact area between the failure mode contact element, or its contact portion, respectively, and the lower electrode may be provided. A suitable solder material may for example comprises or consists of silver, lead, or tin. This embodiment may furthermore be advantageous together with the feature of the failure mode contact element being at least partly coated with a precious metal. In detail, such a coating prevents oxides to be formed and improves the adhesion of the solder after the soldering process.

Next to or additionally to providing a solder material at the at least one contact portion, for example by a coating step, it may be preferred to provide a solder material on the surface of the lower electrode facing the at least one contact portion. This embodiment may be preferred in order to generate a brazed or soldered connection between the lower electrode and the failure mode contact element like described above.

It may furthermore be preferred that the at least one contact portion is rounded at its bottom side. This arrangement minimizes the magnitude of present electric fields between the contact portion and the lower electrode and thus reduces the risk of partial discharges or electrical insulation breakdowns under normal operating conditions. A rounded form in the sense of the present invention may thereby particularly mean a conical, semicircular, or spherical form.

In a further preferred embodiment of the present invention, the at least one contact portion may be spaced apart from the lower electrode with a distance of ≥ 0,5mm in a regular working mode of the power semiconductor arrangement. This allows generating especially stable operation conditions in a regular working mode. In detail, under regular operation conditions, high voltages occur between the lower electrode and the contact portion, or the failure mode contact element, respectively. Consequently, by arranging the at least one contact portion spaced apart from the lower electrode with a distance of ≥ 0,5mm, a sufficiently high clearance distance may be provided in order to avoid partial discharges or electrical insulation breakdowns or the like under normal operating conditions. However, the distance may preferably be chosen in dependence of the maximum voltage used.

It may furthermore be preferred that the low temperature melting material has a melting point of ≤ 700°C.This allows ensuring that the low temperature melting material melts in case an electronic device has a failure and thus that the desired short-circuit failure mode capability is formed. Consequently, a power semiconductor arrangement according to this embodiment has a further improved reliability.

Preferably, the low temperature melting material may at least partly be formed of tin, lead, aluminium, indium or an alloy of the aforementioned metals. These materials and especially the alloys, such as Al-Si or Al-Ge, have advantageous properties with respect to the desired application. In detail, creepage, or a deformation, respectively, of the low temperature melting material is avoided or at least reduced to a sufficiently high degree so that a required clearance distance between the at least one contact portion and the lower electrode is not infringed even under long-term mechanical load exceeded by the failure mode contact element. Consequently, a power semiconductor arrangement according to this embodiment provides a further improved durability. Additionally, the aforementioned compounds provide suitable electrical conductivity in order to allow the power semiconductor arrangement to work properly. Consequently, a low temperature melting material provides a melting point being low enough to ensure that the required short-circuit failure mode is formed in an appropriate time and with a good reliability.

Additionally or alternatively it may be provided that the low temperature material is reinforced. This may be realized, for example, by embedding small particles or fibres, for example having a particle size of ≤ 100µm, in a matrix of the aforementioned or further compounds. This leads to the low melting material to be reinforced and thus to be more resistant against creeping, for example, resulting in an improved reliability. The particles may be chosen in dependence of their properties. In detail, a high elastic modulus and a low coefficient of thermal expansion may be preferred. Suitable compounds may thus comprise aluminium oxide (Al₂O₃), silicium carbide (SiC), aluminium nitride (AIN) or silicium dioxide (SiO₂).

According to a further preferred embodiment of the present invention, the low temperature melting material is capable of forming an alloy with the semiconductor of the semiconductor device. According to this embodiment, the low melting material additionally takes the task of forming an alloy with the semiconductor and thus of forming a conductive path in case of a failure. Consequently, a single alloy-forming layer may be omitted leading to an improved and cost-saving manufacturing procedure.

It may furthermore be preferred that the low temperature melting material is formed as one of a layer or a plurality of single spots, or pins, respectively. By providing a layer of the low temperature melting material, the generation of the arrangement according to the invention is very simple and cost saving. By providing a plurality of single spots of the low temperature melting material, less amount of the material has to melt in case of a failure which may accelerate the formation of a failure mode and may thus further improve the reliability.

The invention furthermore relates to a power semiconductor module comprising a power semiconductor arrangement according to the invention.

### Brief description of drawings

Additional features, characteristics and advantages of the subject-matter of the invention are disclosed in the subclaims, the figures and the following description of the respective figures and examples, which -in an exemplary fashion- show one embodiment and example of a semiconductor module according to the invention.

In the figures:

Figure 1 shows a sectional side view of an embodiment of a power semiconductor arrangement according to the invention in a regular working mode;

Figure 2 shows a sectional side view of an embodiment of a power semiconductor arrangement according to the invention in a short circuit failure mode.

### Description of embodiments

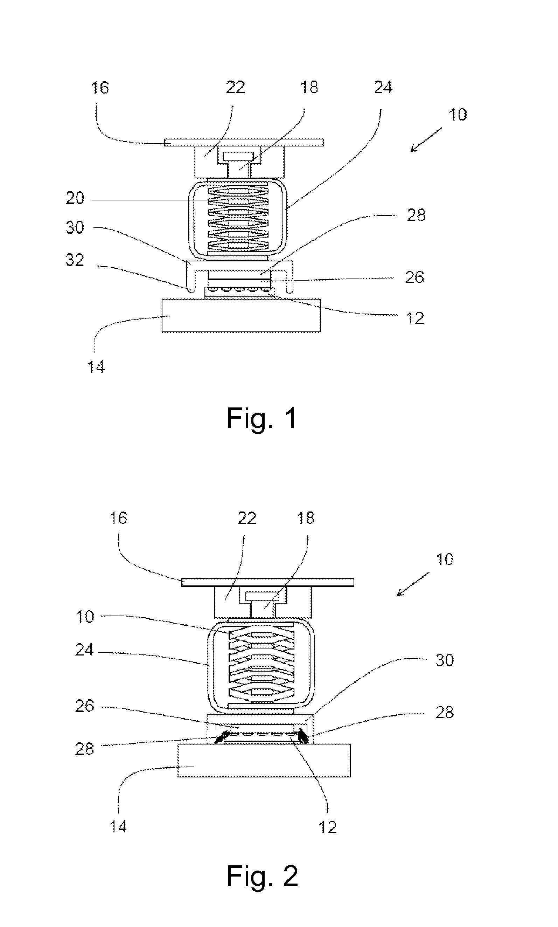

In figure 1, an embodiment of the power semiconductor arrangement 10 according to the invention is schematically shown. The power semiconductor arrangement 10 comprises a power semiconductor device 12 having a first main electrode and a second main electrode electrode and optionally further electrodes such as a control electrode. The power semiconductor device 12 may be an insulated gate bipolar transistor (IGBT), a reverse conductive insulated gate bipolar transistor (reverse conducting IGBT), a bi-mode insulated gate transistor (BIGT) and/or a diode, for example. The first main electrode may be the emitter electrode of the power semiconductor device 12 and the second main electrode may be the collector electrode of it. However, it could also be vice versa. The optional control electrode may be the gate electrode. Further, the power semiconductor device 12 is not limited to the above described examples.

The second main electrode of the power semiconductor device 12 is electrically connected to a lower electrode 14 of the arrangement 10, for example a base plate, wherein the first main electrode of the power semiconductor arrangement 12 is electrically connected to an upper electrode 16 of the arrangement 10, for example a lid of the arrangement 10.

Preferably on top of the semiconductor device 12, a layer 26 of a compound forming an electrically conductive alloy with the silicon of the power semiconductor device 12 due to heat influence generated by a defect in the semiconductor device 12 may be provided. This allows providing a current path in case of a failure of the power semiconductor device 12. The layer 26 may be formed of a material such as aluminium, silver, copper or gold.

According to the invention, the arrangement further comprises a low temperature melting material 28. The low temperature melting material 28 should have a melting temperature which is low enough to ensure that it melts at a temperature range which is reached when a failure occurs in the semiconductor device 12. For example, the low temperature melting material 28 may be formed of tin, lead, aluminium, indium or an alloy of the aforementioned metals and/ or it may be reinforced for example by embedding small particles or fibres into a main matrix of the aforementioned materials or other materials. It is especially preferred that the low temperature melting material 28 has a melting temperature lying in the range of ≤ 700°C, especially preferred in the range of ≥ 150°C to ≤ 700°C. With respect to the shape of the low temperature melting material 28, it may be formed as a layer preferably being arranged on top of the layer 26. Alternatively, the low temperature melting material 28 may be formed as a plurality of single spots. If the layer 26 is missing, the low temperature melting material 28 could also be provided on top of the semiconductor device 12.

Additionally, by appropriately choosing the material acting as low temperature melting material, the latter may as well act as material forming an alloy with the semiconductor of the semiconductor device 14.

Furthermore, the arrangement 10 according to the invention comprises a failure mode contact element 30. The failure mode contact element 30 has at least one contact portion 32 being spaced apart from the lower electrode 14 in a distance being smaller or equal than the thickness of the low temperature melting material 28 in a regular working mode. It may be preferred that the at least one contact portion 32 is spaced apart from the lower electrode 14 with a distance of ≥ 0,5mm in a regular working mode. The failure mode contact element 30 may be at least partly formed from molybdenum, aluminium and/or copper or an alloy containing molybdenum, aluminium and/or copper.

With respect to its shape, the failure mode contact element 30 may be formed by a basic layer proceeding above the plane of the semiconductor device 12, wherein the at least one contact portion 32 proceeds at least partly in a direction being directed towards the lower electrode 14. This can be seen in figure 1. In detail, the basic layer of the failure mode contact element 30 proceeds parallel or essentially parallel to the semiconductor device 12 and thus to the lower electrode 14 and the upper electrode 16. In other words, the basic layer proceeds in a plane between the power semiconductor device 12 and the upper electrode 16. It may be preferred that one contact portion 32 is present being formed ring-shaped. Alternatively, a plurality of contact portions 32 may be provided being designed as contact pins. In the latter cases either the contact pins or the ring shaped contact portions may be arranged on the lower side of the failure mode contact element 30 and proceed essentially in a plane perpendicular to the basic layer.

Apart from that, the at least one contact portion 32 is preferably rounded at its bottom side in order to ensure safe conditions at a regular working mode. In detail electric fields may be reduced due to this measure and thus the risk of partial discharges or electrical insulation breakdowns is minimized or completely circumvented.

It may furthermore be seen in figure 1 that the low temperature melting material 28 may be arranged between the failure mode contact element 30 and the semiconductor device 12. Additionally, the failure mode contact element 30 is spring loaded towards the low temperature melting material 28. The spring load may preferably be realized by a contact piston 18 acting on the failure mode contact element. However, a spring load for the failure mode contact element 30 may be realized in any way a current bypass may be generated by the failure mode contact element 30 in case of a failure of the semiconductor device 12.

In the embodiment shown in figure 1, the contact piston 18 may be provided preferably being spring loaded, preferably by a spring 20. The contact piston 18 presses the failure mode contact device 30, the low temperature melting material 28, the layer 26 and the semiconductor device 12 towards the lower electrode 14. The contact piston 18 may be connected to the upper electrode 16 by one or more electrically conductive connectors 22. Additionally, at least partly surrounding the spring 20 and the contact piston 18, at least one current bypass 22 may be provided.

The effect of a power semiconductor arrangement according to the invention is shown in figure 2. In detail, figure 2 shows the power semiconductor arrangement 10 after a defect in the semiconductor device 12, wherein the same or comparable structural elements are described with the same reference numbers with respect to figure 1. Like described above, a failure in the semiconductor device 12 may lead to a short circuit which generates heat. Due to the preferable provision of the layer 26 being at least partly formed from a material being able to form an eutectic mixture, or alloy, respectively with the silicon of the semiconductor device 12, a conductive channel is formed through the power semiconductor device being able to carry current. The generated heat leads to the low temperature melting material 28 to be melt. The spring loaded failure mode contact element 30 in turn will be pressed downwards, in the direction of the lower electrode 14, thereby forcing the molten low temperature melting materiel 28 aside. This movement allows that the at least one contact portion 32 of the failure mode contact element 30 coming in contact with the lower electrode 14. Consequently, a further electrically conductive channel is formed in parallel to the failed power semiconductor device 12 through which even a high electrical current may flow. The electrical and mechanical connection of the failure mode contact element 30 to the upper electrode 16 may be formed as described with respect to figure 1.

In order to achieve a well-defined movement of the failure mode contact element 30, at least one passage may be provided in the latter. A well-defined movement may be hampered by silicone gel which may be present around the arrangement 10, in particular on top of the lower electrode 14, and is used as an insulating material. In order to improve the movement of the failure mode contact element 30 the at least one passage may be provided in or at the failure mode contact element 30.

The at least one passage may exemplarily be provided in the at least one contact portion 32 as a cut out of the ring-shaped contact portion 32. By this cut out a passage is formed. This allows to prevent silicone gel to deteriorate the movement behaviour of the failure mode contact element 30 because the silicone gel may slip through the at least one passage. Furthermore, the passage(s) may serve to let the molten low melting material 28 pass through in order to improve the movement of the failure mode contact element 30 and thus to improve the reliability.

In the above described embodiment of the contact portion 32 being formed by contact pins, the passages are formed by the space between adjacent pins.

Additionally, to provide a reliable and durable contact of the failure mode contact element 30, or of the at least one contact portion 32 of the latter, the at least one contact portion 32 may be provided with a solder material. For example, the at least one contact portion 32 may at least partly be coated with a solder material at its bottom side, which is facing towards the lower electrode 14. Consequently, a brazed or soldered connection may be formed due to the heat generated by the short circuit leading to an especially stable connection. Alternatively, a solder material may be provided at least on portion of the surface of the lower electrode 14 facing the at least one contact portion 32 in order to generate a brazed or soldered connection with the failure mode contact element 30.

Apart from that, the failure mode contact element 30 may be at least partly coated with silver or gold to improve the contact resistance between the failure mode contact element 30, or the at least one contact portion 32 of the latter, and the lower electrode 14. The current flowing properties may additionally be improved by ensuring that the contact portions have a sufficiently large diameter, or cross section, respectively. Suitable cross sections are lying in the range of 1mm².

In a further embodiment of the invention, the power semiconductor arrangement 10 according to the invention is used in a power semiconductor module. It is obvious for one skilled in the art that a plurality of arrangements 10 shown in figure 1 may be combined to form the power semiconductor module. The arrangement 10 according to the invention is particularly suitable for a high-voltage direct current (HVDC) - electric power transmission system or a flexible AC transmission system (FACTS).

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

### Reference signs list

- 10: power semiconductor arrangement
- 12: power semiconductor device
- 14: lower electrode
- 16: upper electrode
- 18: contact piston
- 20: spring
- 22: connector
- 24: bypass
- 26: layer
- 28: low temperature melting material
- 30: failure mode contact element
- 32: contact portion

## Claims

1. Power semiconductor arrangement comprising a power semiconductor device (12), the power semiconductor device having a first main electrode and a second main electrode, wherein the second main electrode is electrically connected to a lower electrode (14) of arrangement (10) and wherein the first main electrode is electrically connected to an upper electrode (16) of the arrangement (10), wherein the arrangement (10) further comprises a failure mode contact element (30) and a low temperature melting material (28), the low temperature melting material (28) being arranged between the failure mode contact element (30) and the semiconductor device (12), wherein the failure mode contact element (30) is spring loaded towards the low temperature melting material (28) and comprises at least one contact portion (32) being spaced apart from the lower electrode (14) in a distance being smaller or equal than the thickness of the low temperature melting material (28) in a regular working mode of the power semiconductor arrangement (10).

2. Power semiconductor arrangement according to claim 1, wherein the failure mode contact element (30) is spring loaded towards the low temperature melting material (28) by a contact piston (18).

3. Power semiconductor arrangement according to claim 1 or 2, wherein the failure mode contact element (30) comprises a layer proceeding in a plane between the power semiconductor device (12) and the upper electrode (16) and wherein the at least one contact portion (32) proceeds at least partly in a direction being directed towards the lower electrode (14).

4. Power semiconductor arrangement according to any of the preceding claims, wherein the failure mode contact element (30) is at least partly formed from molybdenum, aluminium or copper or from an alloy containing molybdenum, aluminium or copper.

5. Power semiconductor arrangement according to any of the preceding claims, wherein the failure mode contact element (30) is at least partly coated with a precious metal, such as silver or gold.

6. Power semiconductor arrangement according to any of the preceding claims, wherein one contact portion (32) is provided being formed ring-shaped or wherein a plurality of contact portions (32) are provided being designed as contact pins.

7. Power semiconductor arrangement according to any of the preceding claims, wherein at least one passage is provided in the failure mode contact element (30), in particular in the at least one contact portion (32).

8. Power semiconductor arrangement according to any of the preceding claims, wherein a solder material is provided arranged at a side of the at least one contact portion (32) facing towards the lower electrode (14) and/or a solder material is provided at least on portion of the surface of the lower electrode (14) facing the at least one contact portion (32).

9. Power semiconductor arrangement according to any of the preceding claims, wherein the at least one contact portion (32) is rounded at its side facing the lower electrode (14).

10. Power semiconductor arrangement according to any of the preceding claims, wherein the at least one contact portion (32) is spaced apart from the lower electrode (14) with a distance of ≥ 0,5mm in a regular working mode of the power semiconductor arrangement (10).

11. Power semiconductor arrangement according to any of the preceding claims, wherein the low temperature melting material (28) has a melting point of ≤ 700°C.

12. Power semiconductor arrangement according to any of the preceding claims, wherein the low temperature melting material (28) is at least partly formed of tin, lead, aluminium, indium or an alloy of the aforementioned metals and/or wherein the low temperature material (28) is reinforced.

13. Power semiconductor arrangement according to any of the preceding claims, wherein the low temperature melting material is capable of forming an alloy with the semiconductor of the semiconductor device (14).

14. Power semiconductor arrangement according to any of the preceding claims, wherein the low temperature melting material (28) is formed as one of a layer or a plurality of single spots.

15. Power semiconductor module comprising a power semiconductor arrangement (10) according to any of the preceding claims.
